# EUROPEAN PATENT SPECIFICATION

(11) **EP 2 638 408 B1**
(45) Date of publication and mention of the grant of the patent: **30.12.2020**
(21) Application number: 11790701.4
(22) Date of filing: 11.11.2011
(51) Int. Cl.: G01R 31/3185

(54) **FEEDBACK SCAN ISOLATION AND SCAN BYPASS ARCHITECTURE**
RÜCKKOPPLUNGSSCANISOLIERUNG UND SCANBYPASSARCHITEKTUR
ISOLATION DE BALAYAGE DE RETOUR ET ARCHITECTURE DE CONTOURNEMENT DE BALAYAGE

(30) Priority: 11.11.2010 US 944090
(43) Date of publication of application: 18.09.2013
(73) Proprietor: Qualcomm Incorporated, San Diego, CA 92121 (US)
(72) Inventor: POLICKE, Paul F., San Diego, CA 92121 (US); KIM, Hong S., San Diego, CA 92121 (US); BASSETT, Paul Douglas, San Diego, CA 92121 (US)
(74) Representative: Dunlop, Hugh Christopher
(86) International application number: PCT/US2011/060372
(87) International publication number: WO 2012/065064

(56) References cited:
- WO-A1-2007/049172
- US-A- 5 844 921
- SINANOGLU O ET AL: "Isolation Techniques for Soft Cores", IEEE TRANSACTIONS ON COMPUTER AIDED DESIGN OF INTEGRATED CIRCUITS AND SYSTEMS, IEEE SERVICE CENTER, PISCATAWAY, NJ, US, vol. 27, no. 8, 1 August 2008 (2008-08-01) , pages 1453-1466, XP011227374, ISSN: 0278-0070, DOI: 10.1109/TCAD.2008.925794

## Description

### FIELD OF DISCLOSURE

The present disclosure relates generally to the testing of integrated circuit devices, and more particularly to feedback and bypass isolation testing of embedded cores and external circuitry in integrated circuit devices.

### BACKGROUND

Many integrated circuit devices include at least one embedded core and external circuitry that provides inputs to and accepts outputs from the embedded core. The embedded core commonly has a plurality of inputs and outputs. It is advantageous to be able to isolate the embedded core from the external logic for core manufacturing testing, and to isolate the external logic from the embedded core for external logic manufacturing testing. Scan isolation feedback testing can be used to test the core separately from the external logic, and scan isolation bypass testing can be used to test the external circuitry separately from the core. However, scan isolation feedback and bypass testing can be difficult to implement without impacting the silicon area of the integrated circuit device.

Current scan isolation and bypass architectures may require the addition of a state element and a multiplexer for each of the inputs and outputs of the embedded core. This additional circuitry can require a large amount of silicon area on the die, especially when the core has a large number of input and output pins.

It would be desirable to have a scan isolation feedback and bypass architecture that does not need a state element for each input and output of the target core and that uses less silicon area for the scan isolation feedback and bypass circuitry, even when the target core has a large number of inputs and outputs.

Patent US 5,844,921 relates to a hybrid circuit board capable of operating in a functional mode and a test mode includes macro block circuitry and non-macro block circuitry surrounding the macro block circuitry. The circuit board includes a test bridge circuit coupling the macro block circuitry to the surrounding non-macro block circuitry during the functional mode and for bypassing the macro block circuitry during the test mode.

### SUMMARY

A scan isolation and bypass architecture is disclosed that includes core logic, an input isolation multiplexer and an output isolation multiplexer. The core logic receives a core logic input and produces a core logic output. The input isolation multiplexer includes a first input, a second input, a selection input and an output; and the input isolation multiplexer selectively provides one of the first and second inputs to the output based on the selection input. For the input isolation multiplexer, the first input is coupled to a functional input, the second input is coupled to a functional output, the output is coupled to the core logic input, and the selection input is coupled to a first test select signal. The output isolation multiplexer includes a first input, a second input, a selection input and an output; and the output isolation multiplexer selectively provides one of the first and second inputs to the output based on the selection input. For the output isolation multiplexer, the first input is coupled to the core logic output, the second input is coupled to the output of the input isolation multiplexer, the output provides the functional output, and the selection input is coupled to a second test select signal. When the first and second test select signals indicate a core feedback test, the output isolation multiplexer passes the core logic output from the first input of the output isolation multiplexer to the output of the output isolation multiplexer as the functional output, and the input isolation multiplexer passes the core logic output from the second input of the input isolation multiplexer to the output of the input isolation multiplexer and the core logic input. The scan isolation and bypass architecture can be configured so that when the first and second test select signals indicate a bypass test, the input isolation multiplexer passes the functional input from the first input of the input isolation multiplexer to the output of the input isolation multiplexer, and the output isolation multiplexer passes the functional input from the second input of the output isolation multiplexer to the output of the output isolation multiplexer as the functional output. The scan isolation and bypass architecture can be configured so that when the first and second test select signals indicate normal operation, the input isolation multiplexer passes the functional input from the first input of the input isolation multiplexer to the output of the input isolation multiplexer to be processed by the core logic, and the output isolation multiplexer passes the output of the core logic from the first input of the output isolation multiplexer to the output of the output isolation multiplexer as the functional output.

The scan isolation and bypass architecture can also include an at-speed signal and one or both of input AND logic and output AND logic. The input AND logic can include a first input coupled to the at-speed signal, a second input coupled to the functional output, and an output coupled to the second input of the input isolation multiplexer. When the at-speed signal has a first value, the input AND logic passes the functional output to the output of the input AND logic, and when the at-speed signal has a second value the input AND logic prevents the functional output from passing to the output of the input AND logic. The output AND logic can include a first input coupled to the at-speed signal, a second input coupled to the output of the input isolation multiplexer, and an output coupled to the second input of the output isolation multiplexer. When the at-speed signal has the first value, the output AND logic passes the output of the input isolation multiplexer to the output of the output AND logic, and when the at-speed signal has the second value the output AND logic prevents the output of the input isolation multiplexer from passing to the output of the output AND logic.

The scan isolation and bypass architecture can include exclusive-OR logic for situations where the number of functional inputs and outputs are different. When the functional input comprises N inputs and the functional output comprises M outputs, N being greater than M, the exclusive-OR logic can reduce the number of functional inputs to equal the number of functional outputs by receiving the output of the input isolation multiplexer and outputting the reduced output to the second input of the output isolation multiplexer. When the functional output comprises N outputs and the functional input comprises M inputs, the exclusive-OR logic can reduce the number of functional outputs to equal the number of functional inputs by receiving the functional output and an outputting the reduced output to the second input of the input isolation multiplexer.

The scan isolation and bypass architecture can be incorporated into a device selected from a group consisting of a music player, a video player, an entertainment unit, a navigation device, a communications device, a personal digital assistant (PDA), a fixed location data unit, and a computer.

A method of scan isolation and bypass testing for a core coupled to external logic is disclosed where the core has core inputs and core outputs, and the external logic provides functional inputs to the core inputs and accepts functional outputs from the core outputs. The method includes causing the functional inputs from the external logic to bypass the core and pass to the functional outputs when a test selection signal indicates bypass testing; causing the core outputs to feedback to the core inputs when the test selection signal indicates core logic feedback testing; and causing the functional inputs to be processed by the core and the core outputs to pass to the external logic as the functional outputs when the test selection signal indicates normal processing. The core outputs can be provided to the functional outputs when the test selection signal indicates core logic feedback testing. The feedback of the core outputs to the core inputs can be blocked when an at-speed signal indicates the core logic inputs are not synchronized to receive the feedback from the core outputs. The functional inputs from the external logic can be blocked from passing to the functional outputs when an at-speed signal indicates the external logic is not synchronized to receive the functional inputs. When there are more functional inputs than functional outputs and the test selection signal indicates bypass testing, the method can also include combining the functional inputs from the external logic to produce a reduced number of functional inputs equal to the number of functional outputs while bypassing the core, and passing the reduced number of functional inputs to the functional outputs. When there are more functional outputs than functional inputs and when the test selection signal indicates core logic feedback testing, the method can also include combining the core outputs to produce a reduced number of core outputs equal to the number of functional inputs, and feeding back the reduced number of core outputs to the core inputs. The combining can be done using exclusive-or logic.

For a more complete understanding of the present disclosure, reference is now made to the following detailed description and the accompanying drawings.

### BRIEF DESCRIPTION OF THE DRAWINGS

Fig. 1 is a block diagram showing an exemplary core and surrounding isolation circuitry;
Fig. 2 is a block diagram showing an exemplary embodiment of a feedback scan isolation and scan bypass architecture when the number of functional inputs is equal to the number of functional outputs;
Fig. 3 is a block diagram showing an exemplary embodiment of a feedback scan isolation and scan bypass architecture when the number of functional inputs is greater than the number of functional outputs;
Fig. 4 is a block diagram showing an exemplary embodiment of a feedback scan isolation and scan bypass architecture when the number of functional inputs is less than the number of functional outputs;
Fig. 5 is a block diagram showing an exemplary embodiment of a control diagram for a feedback scan isolation and scan bypass architecture; and
Fig. 6 is a block diagram showing an exemplary wireless communication system in which feedback scan isolation and scan bypass architecture may be advantageously employed.

### DETAILED DESCRIPTION

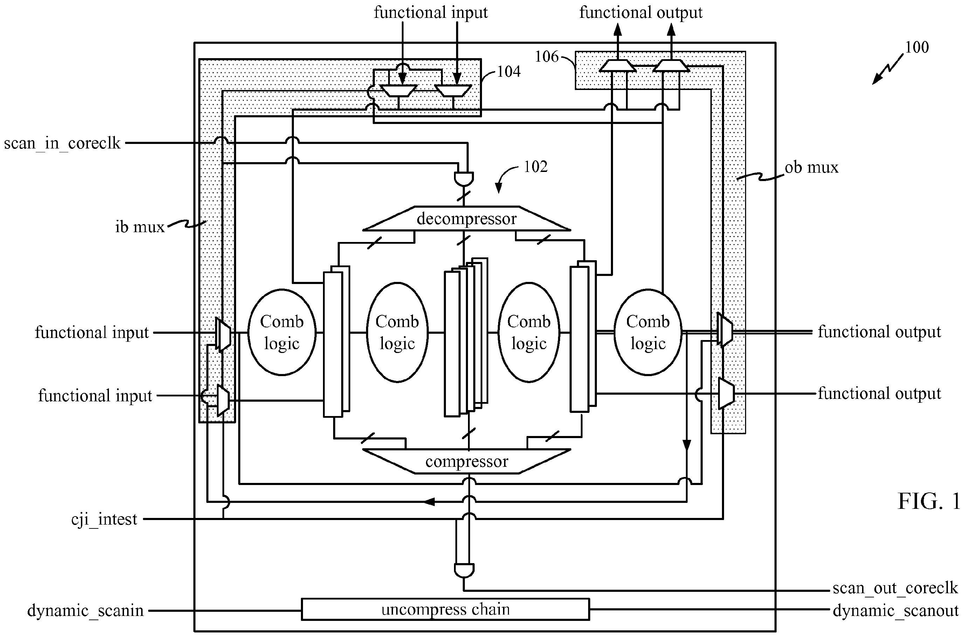

Figure 1 shows an exemplary block diagram 100 of a core 102, an input isolation multiplexer 104 and an output isolation multiplexer 106. The core includes a compressor, a decompressor, combinational logic and various other core logic circuitry. The core 102 receives functional inputs from external logic (not shown) and provides functional outputs to the external logic. The functional inputs from the external logic pass through the input isolation multiplexer 104 into the core 102, and the functional outputs pass from the core 102 through the output isolation multiplexer 106 to the external logic. The core 102 also receives external test control inputs including an in-test signal and an at-speed signal.

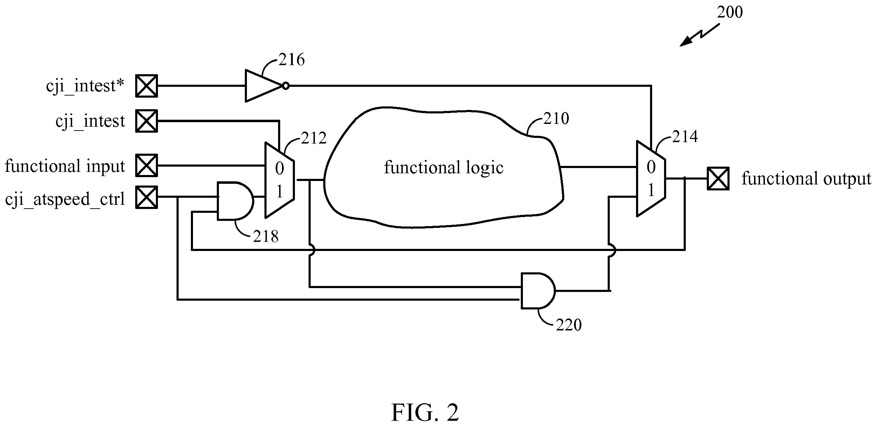

Figure 2 shows a block diagram of an exemplary embodiment of a feedback scan isolation and scan bypass architecture 200 when there are an equal number of functional inputs and functional outputs. The feedback scan isolation and bypass architecture 200 includes functional or core logic 210, an input isolation multiplexer 212 and an output isolation multiplexer 214. The feedback scan isolation and bypass architecture 200 receives functional inputs from external logic (not shown) and supplies functional outputs to the external logic. The feedback scan isolation and bypass architecture 200 also receives an in-test signal, an in-test* signal and an at-speed signal. The in-test signal selects between feedback testing of the core logic or bypass testing of the external logic. The in-test* signal is also used to select between feedback testing or bypass testing, and to select normal, non-test functioning of the core. In feedback testing, the output of the core logic 210 is fed back to the input of the core logic 210. In bypass testing, the input from the external logic bypasses the core logic 210 and is routed to the output of the scan isolation architecture 200. In normal operation, the inputs from the external logic are processed by the core logic and are routed to the output of the scan isolation architecture 200.

The at-speed signal is used when necessary to account for differences in timing between the core logic 210 and the external logic. If clock latency differences are not an issue, the at-speed signal can be removed along with the associated circuitry described below.

It should be noted that there are commonly a plurality of functional inputs and functional outputs, and that the logic blocks in the scan isolation and bypass architecture 200 commonly have a plurality of input/output lines and can include a plurality of instances of the depicted logic device. However, for clarity single instances of the input/output lines and of the logic blocks are shown and explained with regard to Figures 2, 3 and 4.

The functional or core logic 210, which can include a plurality of logic devices and can have a plurality of inputs and outputs, for clarity is represented by a cloud having an input and an output. The input to the core logic 210 is coupled to the output of the input isolation multiplexer 212. The output from the core logic 210 is coupled to an input of the output isolation multiplexer 214.

The input isolation multiplexer 212, which can include a plurality of lines for each of its inputs and outputs and a plurality of 2-to-1 multiplexers, for clarity is represented by a single 2-to-1 multiplexer that includes two inputs, an output and a select input. The first input of the input isolation multiplexer 212 is coupled to the functional input from the external logic. The second input of the input isolation multiplexer 212 is coupled to the output of input AND logic 218. The output of the input isolation multiplexer 212 is coupled to the input of the core logic 210. The output of the input isolation multiplexer 212 is also coupled to an input of the output isolation multiplexer 214 through output AND logic 220. The select input of the input isolation multiplexer 212 is coupled to the in-test signal.

The input AND logic 218, which can include a plurality of lines for each of its inputs and outputs, for clarity is represented by an AND gate having two inputs and an output. The inputs to the input AND logic 218 are coupled to the at-speed signal and to a feedback of the functional output from the scan isolation architecture 200. The input AND logic 218 adjusts for timing differences based on the at-speed signal. Since the functional output commonly includes a plurality of signals, the input AND logic 218 commonly comprises a set of logic to AND the at-speed signal with the functional output. The input AND logic 218 allows the functional output to feedback through to the input isolation multiplexer 212 when the at-speed signal has a first value, and blocks the functional output when the at-speed signal has a second value. If clock speed differences are not an issue, the input AND logic 218 can be removed and the functional output can be coupled directly to the second input of the input isolation multiplexer 212.

The output isolation multiplexer 214, which can include a plurality of lines for each of its inputs and outputs and a plurality of 2-to-1 multiplexers, for clarity is represented by a single 2-to-1 multiplexer that includes two inputs, an output and a select input. The first input of the output isolation multiplexer 214 is coupled to the output from the core logic 210. The second input of the output isolation multiplexer 214 is coupled to the output of the output AND logic 220. The output of the output isolation multiplexer 214 provides the functional output from the scan isolation architecture 200. The select input of the output isolation multiplexer 214 is coupled to the in-test* signal through an inverter 216.

The output AND logic 220, which can include a plurality of lines for each of its inputs and outputs, for clarity is represented by an AND gate having two inputs and an output. The inputs to the output AND logic 220 are coupled to the at-speed signal and to the output of the input isolation multiplexer 212. The output AND logic 220 adjusts for timing differences based on the at-speed signal. Since the output of the input isolation multiplexer 212 commonly includes a plurality of output signals, the output AND logic 220 commonly comprises a set of logic gates to AND the at-speed signal with the output of the input isolation multiplexer 212. The output AND logic 220 allows the output from the input isolation multiplexer 212 to pass through to the output isolation multiplexer 214 when the at-speed signal has a first value, and blocks the output from the input isolation multiplexer 212 when the at-speed signal has a second value. If clock speed differences are not an issue, the output AND logic 220 can be removed and the output from the input isolation multiplexer 212 can be coupled directly to the second input of the output isolation multiplexer 214.

The in-test and in-test* signals can have a first value for bypass or external logic testing where the core logic 210 is bypassed. For the embodiment of Figure 2, bypass testing is indicated when the in-test and in-test* signals have a "0" value. When the in-test signal has a "0" value at the select input of the input isolation multiplexer 212, the input isolation multiplexer 212 passes the functional input from the external logic to the output of the input isolation multiplexer 212. When the in-test* signal has the "0" value, due to the inverter 216, a "1" value is passed to the select input of the output isolation multiplexer 214. With a "1" value at the select input, the output isolation multiplexer 214 passes the output of the output AND logic 220 to the output of the output isolation multiplexer 214 as the functional output to the external logic. Alternatively, the inverter 216 can be eliminated by switching the inputs to the output isolation multiplexer 214 or by switching the polarity of the in-test* input. When the at-speed signal indicates no timing issues, the functional inputs from the external logic pass through the input isolation multiplexer 212, through the output AND logic 220 and through the output isolation multiplexer 214 as the functional output to the external logic. Thus, when the in-test and in-test* signals indicate bypass testing, the core logic 210 is bypassed and the functional inputs from the external logic are passed through the scan isolation architecture 200 to the external logic through the functional output.

The in-test and in-test* signals can have a second value for core logic feedback testing where the output from the core logic 210 is fed back to the input of the core logic 210. For the embodiment of Figure 2, core logic feedback testing is indicated when the in-test and in-test* signals have a "1" value. When the in-test signal has a "1" value at the select input of the input isolation multiplexer 212, the input isolation multiplexer 212 passes the output of the input AND logic 218 to the output of the input isolation multiplexer 212. When the at-speed signal indicates no timing issues, the functional output of the scan isolation architecture 200 is fed back through the input AND logic 218 and through the input isolation multiplexer 212 to the input of the core logic 210. When the in-test signal has this second value for core logic feedback testing, due to the inverter 216, a "0" value is input to the select input of the output isolation multiplexer 214. With a "0" value at the select input, the output isolation multiplexer 214 passes the output of the functional logic 210 to the functional output. Thus, when the in-test and in-test* signals indicate core logic feedback testing and the at-speed signal indicates no timing issues, the output of the core logic 210 passes through the output multiplexer 214 and is fed back through the input AND gate 218 and the input multiplexer 212 to the input of the core logic 210, isolating the core logic 210 from the external logic. The output of the core logic 210 can be monitored at the functional output from the scan isolation architecture 200.

In the exemplary embodiment of Figure 2, normal operation of the scan isolation architecture 200 can be implemented by setting the in-test signal to "0" and setting the in-test* signal to "1". When the in-test signal has a "0" value at the select input of the input isolation multiplexer 212, the input isolation multiplexer 212 passes the functional input from the external logic to the output of the input isolation multiplexer 212. When the in-test* signal has the "1" value, due to the inverter 216, a "0" value is passed to the select input of the output isolation multiplexer 214. With a "0" value at the select input, the output isolation multiplexer 214 passes the output of the core logic 210 to the output of the output isolation multiplexer 214 as the functional output to the external logic. Thus, when the in-test and in-test* signals indicate normal operation, the functional input from the external logic passes through the input multiplexer 212 to be processed by the core logic 210 and the output of the core logic 210 passes through the output multiplexer 214 to the external logic as the functional output of the scan isolation architecture 200.

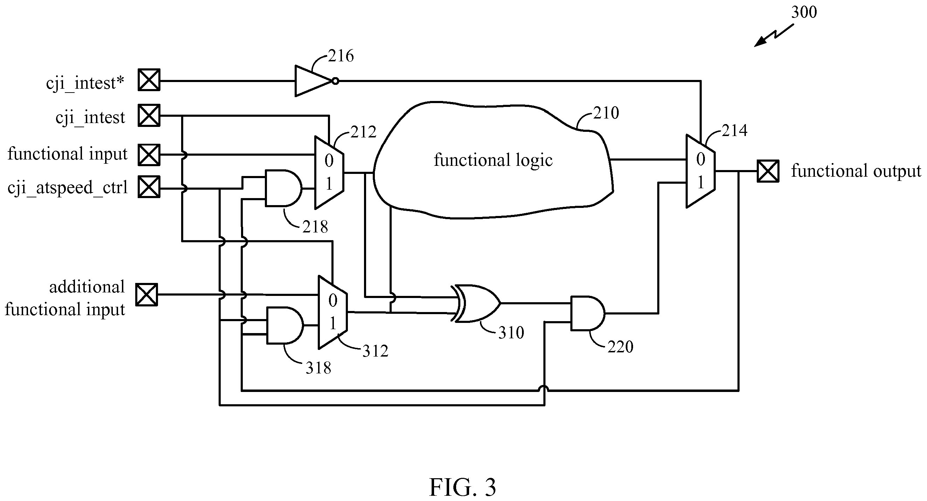

Figure 3 shows a block diagram of an exemplary embodiment of a feedback scan isolation and scan bypass architecture 300 when there are more functional inputs than functional outputs. For example, there can be N functional inputs and M functional outputs, where N > M. The feedback scan isolation and bypass architecture 300 includes the core logic 210, the input isolation multiplexer 212 and the output isolation multiplexer 214. The scan isolation architecture 300 also shows an additional input multiplexer 312 and additional input AND logic 318 for processing the additional functional inputs from the external logic. The scan isolation architecture 300 receives functional inputs from the external logic and supplies functional outputs to the external logic. The scan isolation architecture 300 also receives the in-test signal, the in-test* signal and the at-speed signal. The inputs and processing of the core logic 210, the input isolation multiplexer 212, the output isolation multiplexer 214 and the output AND logic 220 are similar to the processing explained with regard to Figure 2.

The feedback scan isolation and bypass architecture 300 also includes XOR logic 310. Since there are N functional inputs and M functional outputs, the XOR logic 310 comprises a set of logic to reduce the N functional inputs to M functional outputs. For clarity, the XOR logic 310 is represented by an XOR gate having two inputs and an output. The XOR logic 310 receives the outputs from the input isolation multiplexer 212 and from the additional input isolation multiplexer 312. The output of the XOR logic 310 is coupled to an input of the output AND logic 220.

The in-test and in-test* signals can have a first value for bypass or external logic testing where the core logic 210 is bypassed. For the embodiment of Figure 3, bypass testing is indicated when the in-test and in-test* signals have a "0" value. When the in-test signal has a "0" value at the select input of the input isolation multiplexer 212, the input isolation multiplexer 212 passes the functional input from the external logic to the output of the input isolation multiplexer 212. When the in-test signal has a "0" value at the select input of the additional input isolation multiplexer 312, the additional input isolation multiplexer 312 passes the additional functional inputs from the external logic to the output of the additional input isolation multiplexer 312. Thus, the N functional inputs from the external logic pass through the input isolation multiplexers 212, 312 and are input to the XOR logic 310. The XOR logic 310 combines the N functional inputs to provide a reduced set of M outputs at the output of the XOR logic 310. When the at-speed signal indicates no timing issues, the M outputs from the XOR logic 310 pass through the output AND logic 220 to the second input of the output isolation multiplexer 214. When the in-test* signal has the "0" value, due to the inverter 216, a "1" value is passed to the select input of the output isolation multiplexer 214 causing the output isolation multiplexer 214 to pass the output of the output AND logic 220 to the output of the output isolation multiplexer 214 as the M functional outputs to the external logic. Thus, when the in-test and in-test* signals indicate bypass testing and the at-speed signal indicates no timing issues, the core logic 210 is bypassed and the N functional inputs from the external logic pass through the input isolation multiplexers 212, 312, and are reduced by the XOR logic 310 to produce M outputs that pass through the output AND logic 220 and the output isolation multiplexer 214 to the external logic as the functional output of the scan isolation and bypass architecture 300.

The in-test and in-test* signals can have a second value for core logic feedback testing where the output from the core logic 210 is fed back to the input of the core logic 210. For the embodiment of Figure 3, core logic feedback testing is indicated when the in-test and in-test* signals have a "1" value. When the in-test signal has a "1" value at the select input of the input isolation multiplexer 212, the input isolation multiplexer 212 passes the output of the input AND logic 218 to the output of the input isolation multiplexer 212. When the at-speed signal indicates no timing issues, the functional output of the scan isolation architecture 300 is fed back through the input AND logic 218 and through the input isolation multiplexer 212 to the input of the core logic 210. When the in-test signal has a "1" value at the select input of the additional input isolation multiplexer 312, the additional input isolation multiplexer 312 passes the output of the additional input AND logic 318 to the output of the additional input isolation multiplexer 312. When the at-speed signal indicates no timing issues, the functional output of the scan isolation architecture 300 is fed back through the additional input AND logic 318 and through the additional input isolation multiplexer 312 and is provided as an additional input to the functional logic 210. When the in-test* signal has this second value for core logic feedback testing, due to the inverter 216, a "0" value is input to the select input of the output isolation multiplexer 214. With a "0" value at the select input, the output isolation multiplexer 214 passes the output of the core logic 210 to the functional output. Thus, when the in-test and in-test* signals indicate core logic feedback testing and the at-speed signal indicates no timing issues, the M outputs of the functional logic 210 pass through the output multiplexer 214 and are fed back through the input AND logics 218, 318 and the input multiplexers 212, 312 to provide N inputs to the core logic 210. Various methods can be used (for example, replicating, combining and augmenting) to process the M functional outputs of the core logic 210 to provide N functional inputs to the core logic 210. The output of the core logic 210 can be monitored at the functional output of the scan isolation architecture 300.

In the exemplary embodiment of Figure 3, normal operation of the scan isolation architecture 300 can be implemented by setting the in-test signal to "0" and setting the in-test* signal to "1". When the in-test signal has a "0" value, the input isolation multiplexers 212 and 312 pass the functional inputs and additional functional inputs from the external logic to the inputs of the core logic 210. When the in-test* signal has the "1" value, due to the inverter 216, a "0" value is passed to the select input of the output isolation multiplexer 214. With a "0" value at the select input, the output isolation multiplexer 214 passes the output of the core logic 210 to the functional outputs to the external logic. Thus, when the in-test and in-test* signals indicate normal operation, the functional inputs from the external logic pass through the input isolation multiplexers 212, 312 to be processed by the core logic 210 and the output of the core logic 210 passes through the output isolation multiplexer 214 to the external logic as the functional output of the scan isolation architecture 300.

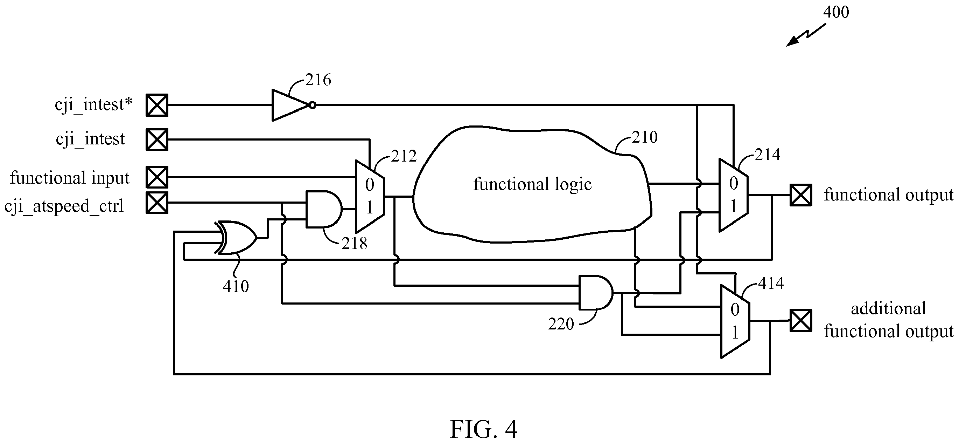

Figure 4 shows a block diagram of an exemplary embodiment of a feedback scan isolation and scan bypass architecture 400 when there are less functional inputs than functional outputs. For example, there can be M functional inputs and N functional outputs, where N > M. The feedback scan isolation and bypass architecture 400 includes the core logic 210, the input isolation multiplexer 212 and the output isolation multiplexer 214. The scan isolation architecture 400 also shows an additional output multiplexer 414 for processing the additional functional outputs from the core logic 210. The scan isolation architecture 400 receives functional inputs from the external logic and supplies functional outputs to the external logic. The scan isolation architecture 400 also receives the in-test signal, the in-test* signal and the at-speed signal. The inputs and processing of the core logic 210, the input isolation multiplexer 212, the output isolation multiplexer 214 and the output AND logic 220 are similar to the processing explained with regard to Figure 2.

The feedback scan isolation and bypass architecture 400 also includes XOR logic 410. Since there are M functional inputs and N functional outputs, the XOR logic 410 comprises a set of logic to reduce the N functional outputs of the core logic 210 to M functional inputs. For clarity, the XOR logic 410 is represented by an XOR gate having two inputs and an output. The XOR logic 410 receives the functional outputs that are output from the output isolation multiplexer 214 and from the additional output isolation multiplexer 414. The output of the XOR logic 410 is coupled to an input of the input AND logic 218.

The in-test and in-test* signals can have a first value for bypass or external logic testing where the core logic 210 is bypassed. For the embodiment of Figure 4, bypass testing is indicated when the in-test and in-test* signals have a "0" value. When the in-test signal has a "0" value at the select input of the input isolation multiplexer 212, the input isolation multiplexer 212 passes the functional input from the external logic to the output of the input isolation multiplexer 212. When the at-speed signal indicates no timing issues, the M functional inputs from the external logic pass through the output AND logic 220 to both the second input of the output isolation multiplexer 214 and the second input of the additional output isolation multiplexer 414. When the in-test* signal has the "0" value, due to the inverter 216, a "1" value is passed to the select inputs of the output isolation multiplexer 214 and of the additional output isolation multiplexer 414. With a "1" value at the select input, the output isolation multiplexer 214 passes the output of the output AND logic 220 to the output of the output isolation multiplexer 214 as the functional outputs to the external logic. With a "1" value at the select input, the additional output isolation multiplexer 414 passes the output of the output AND logic 220 to the output of the additional output isolation multiplexer 414 as the additional functional outputs to the external logic. Thus, when the in-test and in-test* signals indicate external logic testing and the at-speed signal indicates no timing issues, the core logic 210 is bypassed and the M functional inputs from the external logic pass through the input isolation multiplexer 212 and the output AND logic 220, and through the output isolation multiplexers 214, 414 to the external logic as the N functional outputs of the scan isolation and bypass architecture 400. Various methods can be used (for example, replicating, combining and augmenting) to process the M functional inputs from the external logic to provide N functional outputs to the external logic.

The in-test and in-test* signals can have a second value for core logic feedback testing where the output from the functional logic 210 is fed back to the input of the core logic 210. For the embodiment of Figure 4, core logic feedback testing is indicated when the in-test and in-test* signals have a "1" value. The N functional outputs that are output by the output isolation multiplexers 214, 414 are fed back to the inputs of the XOR logic 410. The XOR logic 410 combines the N functional outputs to produce a reduced set of M outputs at the output of the XOR logic 410. The M outputs of the XOR logic 410 are coupled to the input AND logic 218. When the in-test signal has a "1" value at the select input of the input isolation multiplexer 212, the input isolation multiplexer 212 passes the output of the input AND logic 218 to the output of the input isolation multiplexer 212. When the at-speed signal indicates no timing issues, the N functional outputs of the scan isolation architecture 400 are fed back through and reduced by the XOR logic 410 to produce M outputs that are passed through the input AND logic 218 and the input isolation multiplexer 212 as the M inputs to the core logic 210. When the in-test* signal has this second value for core logic feedback testing, due to the inverter 216, a "0" value is input to the select inputs of the output isolation multiplexer 214 and the additional output isolation multiplexer 414. With a "0" value at the select inputs, the output isolation multiplexers 214, 414 pass the outputs of the core logic 210 to the functional outputs and additional functional outputs of the scan isolation architecture 400. Thus, when the in-test and in-test* signals indicate core logic feedback testing and the at-speed signal indicates no timing issues, the N outputs of the core logic 210 pass through the output multiplexers 214, 414 and are fed back through the XOR logic 410 which reduces/combines the functional outputs to produce M outputs that pass through the input AND logic 218 and the input multiplexer 212 to provide M inputs to the core logic 210.

In the exemplary embodiment of Figure 4, normal operation of the scan isolation architecture 400 can be implemented by setting the in-test signal to "0" and setting the in-test* signal to "1". When the in-test signal has a "0" value, the input isolation multiplexer 212 passes the functional input from the external logic to the input of the core logic 210. When the in-test* signal has the "1" value, due to the inverter 216, a "0" value is passed to the select inputs of the output isolation multiplexers 214, 414. With a "0" value at the select inputs, the output isolation multiplexers 214, 414 pass the outputs of the core logic 210 to the functional outputs and additional functional outputs. Thus, when the in-test and in-test* signals indicate normal operation, the functional inputs from the external logic pass through the input isolation multiplexer 212 to be processed by the core logic 210 and the output of the core logic 210 passes through the output isolation multiplexers 214, 414 to the external logic as the functional outputs of the scan isolation architecture 400.

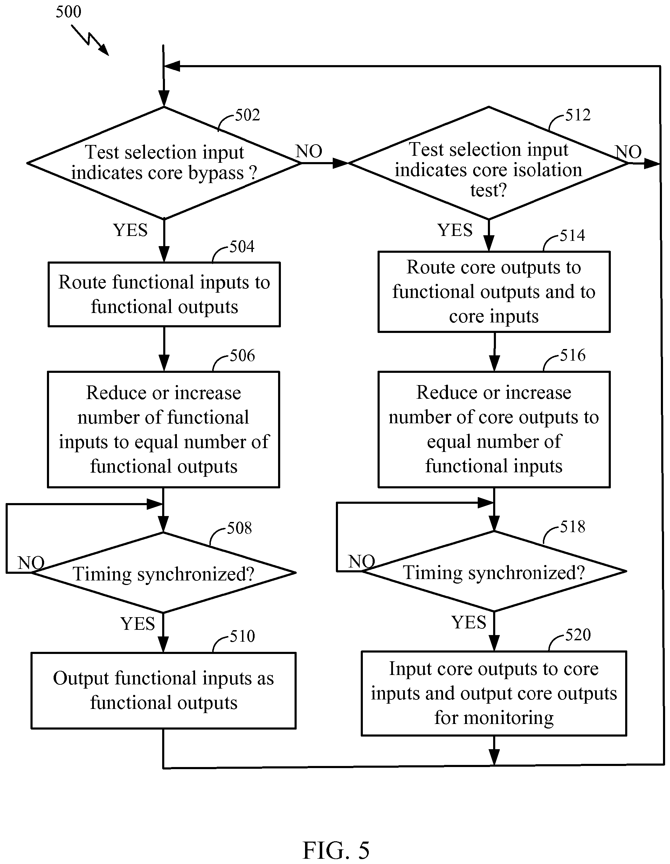

Figure 5 shows an exemplary control diagram 500 for a feedback scan isolation and scan bypass system. At block 502, it is determined whether a test selection input indicates core bypass testing. The test selection input could be the in-test signal described in the embodiments of Figures 2, 3 and 4. If the test selection input indicates core bypass testing, control is passed to block 504. If the test selection input does not indicate core bypass testing, control is passed to block 512.

At block 504, core bypass testing is started by routing the functional inputs to the system to the functional outputs of the system, and control passes to block 506. At block 506, the number of functional inputs can be increased or reduced as necessary so the number of functional inputs equals the number of functional outputs. The number of functional inputs can be reduced using XOR logic 310 as shown in Figure 3, or by ignoring the excess inputs, or by other methods. The number of functional inputs can be increased by routing certain inputs to multiple outputs, or by augmenting the functional inputs with additional signals of known or unspecified values, or by other methods. After any necessary increasing or reducing of the number of functional inputs, control passes to block 508.

At block 508, it is determined whether timing is synchronized to output the functional inputs of the system to the external logic. Timing synchronization can be checked using an at-speed signal as explained in the embodiments of Figures 2, 3 and 4. In some systems, it may not be necessary to check timing. If the timing is not synchronized, control stays at block 508 until the timing is synchronized. Once the timing is synchronized, control passes to block 510 where the functional inputs, with any necessary increase or reduction, are output to the external logic as functional outputs. From block 510, control can return to block 502 to check for further testing.

At block 512, it is determined whether a test selection input indicates core isolation testing. If the test selection input indicates core isolation testing, control is passed to block 514. If the test selection input does not indicate core isolation testing, control can return to block 502 to check for testing.

At block 514, core isolation testing is started by routing the core outputs, such as the outputs of the functional logic 210, to the functional outputs of the system and to the core inputs. Control then passes to block 516. At block 516, the number of core outputs can be increased or reduced as necessary so the number of core outputs equals the number of functional inputs. The number of core outputs can be reduced using XOR logic 410 as shown in Figure 4, or by ignoring the excess outputs, or by other methods. The number of core outputs can be increased by routing certain core outputs to multiple core inputs, or by augmenting the core outputs with additional signals of known or unspecified values, or by other methods. After any necessary increasing or reducing of the number of core outputs, control passes to block 518.

At block 518, it is determined whether timing is synchronized to input the feedback of the core output to the inputs of the core logic. Timing synchronization can be checked using an at-speed signal as explained in the embodiments of Figures 2, 3 and 4. In some systems, it may not be necessary to check timing. If the timing is not synchronized, control stays at block 518 until the timing is synchronized. Once the timing is synchronized, control passes to block 520 where the core outputs, with any necessary increase or reduction, are input to the core logic as functional inputs. The core outputs can also be made available for monitoring. The monitoring output may not be dependent on the timing synchronization. From block 520 control can return to block 502 to check for further testing.

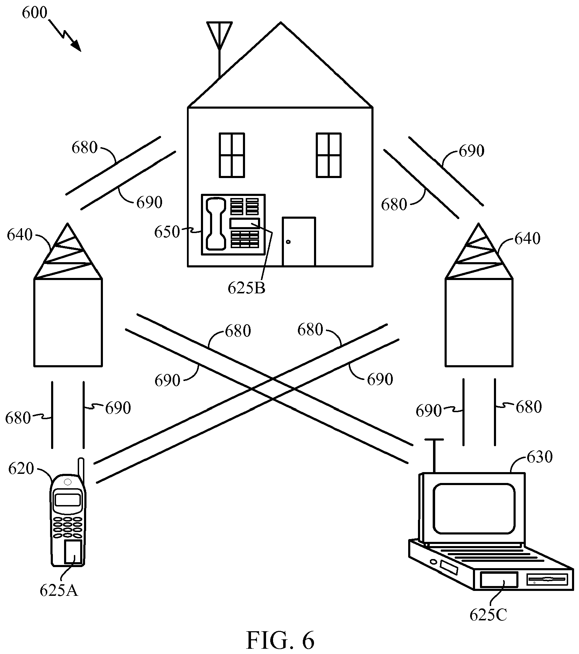

Figure 6 shows an exemplary wireless communication system 600 in which an embodiment of the feedback scan isolation and bypass architecture may be advantageously employed. For purposes of illustration, Figure 6 shows three remote units 620, 630, and 650 and two base stations 640. It should be recognized that typical wireless communication systems may have many more remote units and base stations. Any of the remote units 620, 630, and 650 may include the feedback scan isolation and bypass architecture as disclosed herein. Figure 6 shows forward link signals 680 from the base stations 640 and the remote units 620, 630, and 650 and reverse link signals 690 from the remote units 620, 630, and 650 to base stations 640.

In Figure 6, remote unit 620 is shown as a mobile telephone, remote unit 630 is shown as a portable computer, and remote unit 650 is shown as a fixed location remote unit in a wireless local loop system. For example, the remote units may be cell phones, hand-held personal communication systems (PCS) units, portable data units such as personal data assistants, or fixed location data units such as meter reading equipment. Although Figure 6 illustrates certain exemplary remote units that may include the feedback scan isolation and bypass architecture as disclosed herein, the architectures and methods as disclosed herein are not limited to these exemplary illustrated units. Embodiments may be suitably employed in any electronic device in which feedback scan isolation and bypass architectures are desired.

While exemplary embodiments incorporating the principles of the present invention have been disclosed hereinabove, the present invention is not limited to the disclosed embodiments. After reading the present disclosure, those of skill in the art will realize many variations can be made, for example the feedback from the output of the output isolation multiplexer 214 in Figures 2-4 can alternatively be taken from the outputs of the core logic 210. The present application is intended to cover any variations, uses, or adaptations of the invention using its general principles. Further, this application is intended to cover such departures from the present disclosure as come within known or customary practice in the art to which this invention pertains and which fall within the limits of the appended claims.

## Claims

1. A scan isolation and bypass architecture comprising
core logic having a core logic input and a core logic output;
an input isolation multiplexer (212) having a first input, a second input, a selection input and an output, the input isolation multiplexer (212) selectively providing one of the first and second inputs of the input isolation multiplexer to the output of the input isolation multiplexer based on the selection input of the input isolation multiplexer (212), the first input of the input isolation multiplexer (212) being coupled to a functional input, the second input of the input isolation multiplexer (212) being coupled to a functional output, the output of the input isolation multiplexer (212) being coupled to the core logic input, and the selection input of the input isolation multiplexer (212) being coupled to a first test select signal;
an output isolation multiplexer (214) having a first input, a second input, a selection input and an output, the output isolation multiplexer (214) selectively providing one of the first and second inputs of the output isolation multiplexer to the output of the output isolation multiplexer (214) based on the selection input of the output isolation multiplexer (214), the first input of the output isolation multiplexer (214) being coupled to the core logic output, the second input of the output isolation multiplexer being coupled to the output of the input isolation multiplexer (212), the output of the output isolation multiplexer (214) providing the functional output, and the selection input of the output isolation multiplexer (214) being coupled to a second test select signal;
wherein when the first and second test select signals indicate a core feedback test, the output isolation multiplexer (214) passes the core logic output from the first input of the output isolation multiplexer (214) to the output of the output isolation multiplexer (214) as the functional output, and the input isolation multiplexer (212) passes the core logic output from the second input of the input isolation multiplexer (212) to the output of the input isolation multiplexer (212) and the core logic input.

2. The scan isolation and bypass architecture of claim 1, wherein when the first and second test select signals indicate a bypass test, the input isolation multiplexer (212) passes the functional input from the first input of the input isolation multiplexer (212) to the output of the input isolation multiplexer (212), and the output isolation multiplexer passes the functional input from the second input of the output isolation multiplexer (214) to the output of the output isolation multiplexer (214) as the functional output.

3. The scan isolation and bypass architecture of claim 2, wherein when the first and second test select signals indicate a normal operation, the input isolation multiplexer (212) passes the functional input from the first input of the input isolation multiplexer (212) to the output of the input isolation multiplexer (212) to be processed by the core logic, and the output isolation multiplexer (214) passes the output of the core logic from the first input of the output isolation multiplexer (214) to the output of the output isolation multiplexer (214) as the functional output.

4. The scan isolation and bypass architecture (200, 300, 400) of claim 2 or 3, further comprising an at-speed signal and input AND logic (218), the input AND logic (218) comprising:
a first input coupled to the at-speed signal,
a second input coupled to the functional output, and
an output coupled to the second input of the input isolation multiplexer (212);
wherein when the at-speed signal has a first value the input AND logic (218) passes the functional output to the output of the input AND logic (218), and when the at-speed signal has a second value the input AND logic (218) prevents the functional output from passing to the output of the input AND logic.

5. The scan isolation and bypass architecture (200, 300, 400) of claim 4, further comprising output AND logic (220) comprising:
a first input coupled to the at-speed signal,
a second input coupled to the output of the input selection means (212), and
an output coupled to the second input of the output isolation multiplexer (214); wherein when the at-speed signal has the first value the output AND logic passes the output of the input isolation multiplexer (212) to the output of the output AND logic (220), and when the at-speed signal has the second value the output AND logic (220) prevents the output of the input isolation multiplexer (212) from passing to the output of the output AND logic (220).

6. The scan isolation and bypass architecture (200, 300, 400) of claim 2 or 3, further comprising an at-speed signal and output AND logic (220), the output AND logic (220) comprising:
a first input coupled to the at-speed signal,
a second input coupled to the output of the input isolation multiplexer (212), and
an output coupled to the second input of the output isolation multiplexer (214);
wherein when the at-speed signal has a first value the output AND logic passes the output of the input isolation multiplexer (212) to the output of the output AND logic (220), and when the at-speed signal has a second value the output AND logic (220) prevents the output of the input isolation multiplexer (212) from passing to the output of the output AND logic (220).

7. The scan isolation and bypass architecture of any preceding claim 1, wherein the functional input comprises N inputs and the functional output comprises M outputs, N being greater than M; and wherein the scan isolation and bypass architecture further comprises:
exclusive-OR logic (310) for reducing the number of functional inputs to equal the number of functional outputs, the exclusive-OR logic (310) comprising:
an input coupled to the output of the input isolation multiplexer (212), and
an output coupled to the second input of the output isolation multiplexer (214), the output of the input isolation multiplexer (212) being coupled to the second input of the output isolation multiplexer (214) through the exclusive-OR logic (310).

8. The scan isolation and bypass architecture of claim 7, further comprising an at-speed signal and output AND logic (318), the output AND logic comprising:
a first input coupled to the at-speed signal,
a second input coupled to the output of the exclusive-OR logic (310), and
an output coupled to the second input of the output isolation multiplexer (214), the output of the exclusive-OR logic (310) being coupled to the second input of the output isolation multiplexer through the output AND logic;
wherein when the at-speed signal has a first value the output AND logic (318) passes the output of the exclusive-OR logic (310) to the output of the output AND logic, and when the at-speed signal has a second value the output AND logic prevents the output of the exclusive-OR logic (310) from passing to the output of the output AND logic.

9. The scan isolation and bypass architecture of claim 1, wherein the functional output comprises N outputs and the functional input comprises M inputs, N being greater than M; and wherein the scan isolation and bypass architecture further comprises:
exclusive-OR logic (410) for reducing the number of functional outputs to equal the number of functional inputs, the exclusive-OR logic (410) comprising:
an input coupled to the functional output, and
an output coupled to the second input of the input isolation multiplexer (212), the functional output being coupled to the second input of the input isolation multiplexer through the exclusive-OR logic (410).

10. The scan isolation and bypass architecture of claim 9, further comprising an at-speed signal and input AND logic (218), the input AND logic comprising:
a first input coupled to the at-speed signal,
a second input coupled to the output of the exclusive-OR logic (410), and
an output coupled to the second input of the input isolation multiplexer, the output of the exclusive-OR logic (410) being coupled to the second input of the input selection means through the input AND logic (218);
wherein when the at-speed signal has a first value the input AND logic (218) passes the output of the exclusive-OR logic (410) to the output of the input AND logic (218), and when the at-speed signal has a second value the input AND logic (218) prevents the output of the exclusive-OR logic from passing to the output of the input AND logic.

11. The scan isolation and bypass architecture of claim 1 incorporated into a device selected from a group consisting of a music player, a video player, an entertainment unit, a navigation device, a communications device, a personal digital assistant (PDA), a fixed location data unit, and a computer.

12. A method of scan isolation and bypass testing for a core coupled to external logic using a scan isolation and bypass architecture according to any of claims 1 to 11, the core having core inputs and core outputs, the external logic providing functional inputs to the core inputs and accepting functional outputs from the core outputs, the method comprising:
causing the functional inputs from the external logic to bypass the core and pass to the functional outputs when a test selection signal indicates bypass testing;
causing the functional inputs to be processed by the core and the core outputs to pass to the external logic as the functional outputs when the test selection signal indicates normal processing; and
**characterised by** the step of
causing the core outputs to feedback to the core inputs when the test selection signal indicates core logic feedback testing.

13. The method of claim 12, further comprising one or more of the following steps:
i) providing the core outputs to the functional outputs when the test selection signal indicates core logic feedback testing;
ii) blocking the feedback of the core outputs to the core inputs when an at-speed signal indicates the core logic inputs are not synchronized to receive the feedback from the core outputs;
iii) blocking the functional inputs from the external logic from passing to the functional outputs when an at-speed signal indicates the external logic is not synchronized to receive the functional inputs; or
iv) blocking the functional inputs from the external logic from passing to the functional outputs when an at-speed signal indicates the external logic is not synchronized to receive the functional inputs.

14. The method of claim 12, wherein
i) when there are more functional inputs than functional outputs, the method further comprising, when the test selection signal indicates bypass testing:
combining the functional inputs from the external logic to produce a reduced number of functional inputs equal to the number of functional outputs while bypassing the core, and
passing the reduced number of functional inputs to the functional outputs, or
ii) when there are more functional outputs than functional inputs, the method further comprising, when the test selection signal indicates core logic feedback testing:
combining the core outputs to produce a reduced number of core outputs equal to the number of functional inputs, and
feeding back the reduced number of core outputs to the core inputs.

15. The method of claim 14, further comprising one of the following steps:
i) blocking the reduced number of functional inputs from passing to the functional outputs when an at-speed signal indicates the external logic is not synchronized to receive the reduced number of functional inputs; or
ii) blocking the feedback of the reduced number of core outputs to the core inputs when an at-speed signal indicates the core logic inputs are not synchronized to receive the feedback of the reduced number of core outputs; or
iii) wherein the combining is done using exclusive-or logic.

## Patentansprüche

1. Eine Scan-Isolations- und -Umgehungs- bzw. -Bypass-Architektur, die Folgendes aufweist
Kernlogik mit einem Kernlogikeingang und einem Kernlogikausgang;
einen Eingangsisolationsmultiplexer (212) mit einem ersten Eingang, einem zweiten Eingang, einer Auswahleingang und einem Ausgang, wobei der Eingangsisolationsmultiplexer (212) selektiv eine von der ersten und zweiten Eingangsgröße des Eingangsisolationsmultiplexers an den Ausgang des Eingangsisolationsmultiplexer vorsieht basierend auf der Auswahleingangsgröße des Eingangsisolationsmultiplexers (212), wobei der erste Eingang des Eingangsisolationsmultiplexers (212) an einen funktionalen Eingang gekoppelt ist, der zweite Eingang des Eingangsisolationsmultiplexers (212) an einen funktionale Ausgang gekoppelt ist, der Ausgang des Eingangsisolationsmultiplexers (212) an den Kernlogikeingang gekoppelt ist, und der Auswahleingang des Eingangsisolationsmultiplexers (212) an ein erstes Testauswahlsignal gekoppelt ist;
einen Ausgangsisolationsmultiplexer (214) mit einem ersten Eingang, einem zweiten Eingang, einem Auswahleingang und einem Ausgang, wobei der Ausgangsisolationsmultiplexer (214) selektiv eine von der ersten und zweiten Eingangsgröße des Ausgangsisolationsmultiplexers an den Ausgang des Ausgangsisolationsmultiplexers (214) vorsieht basierend auf der Auswahleingangsgröße des Ausgangsisolationsmultiplexers (214), wobei der erste Eingang des Ausgangsisolationsmultiplexers (214) an den Kernlogikausgang gekoppelt ist, der zweite Eingang des Ausgangsisolationsmultiplexers an den Ausgang des Eingangsisolationsmultiplexers (212) gekoppelt ist, der Ausgang des Ausgangsisolationsmultiplexers (214) die funktionale Ausgangsgröße vorsieht und die Auswahleingangsgröße des Ausgangsisolationsmultiplexers (214) an ein zweites Testauswahlsignal gekoppelt ist; wobei wenn das erste und zweite Testauswahlsignal einen Kernfeedbacktest anzeigen, der Ausgangsisolationsmultiplexer (214) die Kernlogikausgangsgröße von dem ersten Eingang des Ausgangsisolationsmultiplexers (214) an den Ausgang des Ausgangsisolationsmultiplexers (214) als die funktionale Ausgangsgröße weiterleitet, und der Eingangsisolationsmultiplexer (212) die Kernlogikausgangsgröße von dem zweiten Eingang des Eingangsisolationsmultiplexers (212) an den Ausgang des Eingangsisolationsmultiplexers (212) und den Kernlogikeingang weiterleitet.

2. Scan-Isolations- und -Bypass-Architektur nach Anspruch 1, wobei, wenn das erste und zweite Testauswahlsignal einen Umgehungs- bzw. Bypass-Test anzeigen, der Eingangsisolationsmultiplexer (212) die funktionale Eingangsgröße von dem ersten Eingang des Eingangsisolationsmultiplexers (212) an den Ausgang des Eingangsisolationsmultiplexers (212) weiterleitet, und der Ausgangsisolationsmultiplexer die funktionale Eingangsgröße von dem zweiten Eingang des Ausgangsisolationsmultiplexers (214) an den Ausgang des Ausgangsisolationsmultiplexers (214) als die funktionale Ausgangsgröße weiterleitet.

3. Scan-Isolations- und -Bypass-Architektur nach Anspruch 2, wobei, wenn das erste und zweite Testauswahlsignal einen normalen Betrieb anzeigen, der Eingangsisolationsmultiplexers (212) die funktionale Eingangsgröße von dem ersten Eingang des Eingangsisolationsmultiplexers (212) an den Ausgang des Eingangsisolationsmultiplexers (212) weiterleitet, um durch die Kernlogik verarbeitet zu werden, und der Ausgangsisolationsmultiplexer (214) die Ausgangsgröße der Kernlogik von dem ersten Eingang des Ausgangsisolationsmultiplexers (214) an den Ausgang des Ausgangsisolationsmultiplexers (214) als die funktionale Ausgangsgröße weiterleitet.

4. Scan-Isolations- und -Bypass-Architektur (200, 300, 400) nach Anspruch 2 oder 3, die weiter ein At-Speed- bzw. Auf-Geschwindigkeit-Signal und Eingangs-AND-Logik (218) aufweist, wobei die Eingangs-AND-Logik (218) Folgendes aufweist:
einen ersten Eingang, der an das At-Speed-Signal gekoppelt ist,
einen zweiten Eingang, der an den funktionale Ausgang gekoppelt ist, und einen Ausgang, der an den zweiten Eingang des Eingangsisolationsmultiplexers (212) gekoppelt ist;
wobei, wenn das At-Speed-Signal einen ersten Wert hat, die Eingangs-AND-Logik (218) die funktionale Ausgangsgröße an den Ausgang der Eingangs-AND-Logik (218) weiterleitet, und wenn das At-Speed-Signal einen zweiten Wert hat, die Eingangs-AND-Logik (218) verhindert, dass die funktionale Ausgangsgröße zu dem Ausgang der Eingangs-AND-Logik weitergeleitet wird.

5. Scan-Isolations- und -Bypass-Architektur (200, 300, 400) nach Anspruch 4, die weiter Ausgangs-AND-Logik (220) aufweist, die Folgendes aufweist:
einen ersten Eingang, der an das At-Speed-Signal gekoppelt ist,
einen zweiten Eingang, der an den Ausgang der Eingangsauswahlmittel (212) gekoppelt ist, und
einen Ausgang, der an den zweiten Eingang des Ausgangsisolationsmultiplexers (214) gekoppelt ist;
wobei, wenn das At-Speed-Signal den ersten Wert hat, die Ausgangs-AND-Logik die Ausgangsgröße des Eingangsisolationsmultiplexers (212) an den Ausgang der Ausgangs-AND-Logik (220) weiterleitet, und wenn das At-Speed-Signal den zweiten Wert hat, die Ausgangs-AND-Logik (220) verhindert, dass die Ausgangsgröße des Eingangsisolationsmultiplexers (212) an den Ausgang der Ausgangs-AND-Logik (220) weitergeleitet wird.

6. Scan-Isolations- und -Bypass-Architektur (200, 300, 400) nach Anspruch 2 oder 3, die weiter ein At-Speed-Signal und Ausgangs-AND-Logik (220) aufweist, wobei die Ausgangs-AND-Logik (220) Folgendes aufweist:
einen ersten Eingang, der an das At-Speed-Signal gekoppelt ist;
einen zweiten Eingang, der an den Ausgang des Eingangsisolationsmultiplexers (212) gekoppelt ist, und
einen Ausgang, der an den zweiten Eingang des Ausgangsisolationsmultiplexers (214) gekoppelt ist;
wobei, wenn das At-Speed-Signal einen ersten Wert hat, die Ausgangs-AND-Logik die Ausgangsgröße des Eingangsisolationsmultiplexers (212) an den Ausgang der Ausgangs-AND-Logik (220) weiterleitet, und wenn das At-Speed-Signal einen zweiten Wert hat, die Ausgangs-AND-Logik (220) verhindert, dass die Ausgangsgröße des Eingangsisolationsmultiplexers (212) zu dem Ausgang der Ausgangs-AND-Logik (220) weitergeleitet wird.

7. Scan-Isolations- und -Bypass-Architektur nach einem vorhergehenden Anspruch 1, wobei der funktionale Eingang N Eingänge aufweist und der funktionale Ausgang M Ausgänge aufweist, wobei N größer als M ist; und wobei die Scan-Isolations- und -Bypass-Architektur weiter Folgendes aufweist:
Exclusive-OR-Logik (310) zum Verringern der Anzahl von funktionalen Eingängen auf gleich der Anzahl von funktionalen Ausgängen, wobei die Exclusive-OR-Logik (310) Folgendes aufweist:
einen Eingang, der an den Ausgang des Eingangsisolationsmultiplexers (212) gekoppelt ist, und
einen Ausgang, der an den zweiten Eingang des Ausgangsisolationsmultiplexers (214) gekoppelt ist, wobei der Ausgang des Eingangsisolationsmultiplexers (212) an den zweiten Eingang des Ausgangsisolationsmultiplexers (214) durch die Exclusive-OR-Logik (310) gekoppelt ist.

8. Scan-Isolations- und -Bypass-Architektur nach Anspruch 7, die weiter ein At-Speed-Signal und eine Ausgangs-AND-Logik (318) aufweist, wobei die Ausgangs-AND-Logik Folgendes aufweist:
einen ersten Eingang, der an das At-Speed-Signal gekoppelt ist,
einen zweiten Eingang, der an den Ausgang der Exclusive-OR-Logik (310) gekoppelt ist, und
einen Ausgang, der an den zweiten Eingang des Ausgangsisolationsmultiplexers (214) gekoppelt ist, wobei der Ausgang der Exclusive-OR-Logik (310) an den zweiten Eingang des Ausgangsisolationsmultiplexers durch die Ausgangs-AND-Logik gekoppelt ist;
wobei, wenn das At-Speed-Signal einen ersten Wert hat, die Ausgangs-AND-Logik (318) die Ausgangsgröße der Exclusive-OR-Logik (310) an den Ausgang der Ausgangs-AND-Logik weiterleitet, und wenn das At-Speed-Signal einen zweiten Wert hat, die Ausgabe-AND-Logik verhindert, dass die Ausgangsgröße der Exclusive-OR-Logik (310) an den Ausgang der Ausgangs-AND-Logik weitergeleitet wird.

9. Scan-Isolations- und -Bypass-Architektur nach Anspruch 1, wobei der funktionale Ausgang N Ausgänge aufweist und der funktionale Eingang M Eingänge aufweist, wobei N größer als M ist; und wobei die Scan-Isolations- und - Bypass-Architektur weiter Folgendes aufweist:
Exclusive-OR-Logik (410) zum Verringern der Anzahl von funktionalen Ausgängen auf die gleiche Anzahl von funktionalen Eingängen, wobei die Exclusive-OR-Logik (410) Folgendes aufweist:
einen Eingang, der an den funktionalen Ausgang gekoppelt ist, und
einen Ausgang, der an den zweiten Eingang des Eingangsisolationsmultiplexers (212) gekoppelt ist, wobei der funktionale Ausgang an den zweiten Eingang des Eingangsisolationsmultiplexers durch die Exclusive-OR-Logik (410) gekoppelt ist.

10. Scan-Isolations- und -Bypass-Architektur nach Anspruch 9, die weiter ein At-Speed-Signal und Eingangs-AND-Logik (218) aufweist, wobei die Eingangs-AND-Logik Folgendes aufweist
einen ersten Eingang, der an das At-Speed-Signal gekoppelt ist,
einen zweiten Eingang, der an den Ausgang der Exclusive-OR-Logik (410) gekoppelt ist, und
einen Ausgang, der an den zweiten Eingang des Eingangsisolationsmultiplexers gekoppelt ist, wobei der Ausgang der Exclusive-OR-Logik (410) an den zweiten Eingang der Eingangsauswahlmittel durch die Eingangs-AND-Logik (218) gekoppelt ist;
wobei, wenn das At-Speed-Signal einen ersten Wert hat, die Eingangs-AND-Logik (218) die Ausgangsgröße der Exclusive-OR-Logik (410) an den Ausgang der Eingangs-AND-Logik (218) weiterleitet, und wenn das At-Speed-Signal einen zweiten Wert hat, die Eingangs-AND-Logik (218) verhindert, dass die Ausgangsgröße der Exclusive-OR-Logik an den Ausgang der Eingangs-AND-Logik weitergeleitet wird.

11. Scan-Isolations- und -Bypass-Architektur nach Anspruch 1, die in eine Einrichtung integriert ist, die aus einer Gruppe ausgewählt ist, die aus Folgendem besteht: eine Musikabspielvorrichtung, einer Videoabspielvorrichtung, einer Unterhaltungseinheit, einer Navigationseinrichtung, einer Kommunikationseinrichtung, einem persönlichen digitalen Assistenten bzw. PDA, einer Dateneinheit mit festem Standort und einem Computer.

12. Ein Verfahren zur Scan-Isolations- und -Bypass-Testung für einen Core bzw. Kern, der an externe Logik gekoppelt ist unter Verwendung einer Scan-Isolations- und -Bypass-Architektur nach einem der Ansprüche 1 bis 11, wobei der Kern Kerneingänge und Kernausgänge hat, wobei die externe Logik funktionale Eingangsgrößen an die Kerneingänge vorsieht und funktionale Ausgangsgrößen von den Kernausgängen annimmt, wobei das Verfahren Folgendes aufweist:
Bewirken, dass die funktionalen Eingangsgrößen von der externen Logik den Kern umgehen und zu den funktionalen Ausgängen weitergeleitet werden, wenn das Testauswahlsignal Umgehungs- bzw. Bypass-Testung anzeigt;
Bewirken, dass die funktionalen Eingangsgrößen durch den Kern und die Kernausgänge verarbeitet werden, um zu der externen Logik als die funktionalen Ausgangsgrößen weitergeleitet zu werden, wenn das Testauswahlsignal normale Verarbeitung anzeigt; und
**gekennzeichnet durch** den Schritt des
Bewirkens, dass die Kernausgänge ein Feedback an die Kerneingänge geben, wenn das Testauswahlsignal Kernlogikfeedbacktestung anzeigt.

13. Verfahren nach Anspruch 12, das weiter einen oder mehrere der folgenden Schritte aufweist:
i) Vorsehen der Kernausgangsgrößen an die funktionalen Ausgänge, wenn das Testauswahlsignal Kernlogikfeedbacktestung anzeigt;
ii) Blockieren des Feedbacks der Kernausgänge an die Kerneingänge, wenn ein At-Speed-Signal anzeigt, dass die Kernlogikeingänge nicht synchronisiert sind zum Empfangen des Feedbacks von den Kernausgängen;
iii) Abhalten der funktionalen Eingangsgrößen von der externen Logik vom weitergeleitet werden zu den funktionalen Ausgängen, wenn ein At-Speed-Signal anzeigt, dass die externe Logik nicht synchronisiert ist die funktionalen Eingangsgrößen zu empfangen; oder
iv) Abhalten der funktionalen Eingangsgrößen von der externen Logik vom weitergeleitet werden zu den funktionalen Ausgängen, wenn ein At-Speed-Signal anzeigt, dass die externe Logik nicht synchronisiert ist die funktionalen Eingaben zu empfangen.

14. Verfahren nach Anspruch 12, wobei
i) wenn es mehr funktionale Eingänge als funktionale Ausgänge gibt, das Verfahren weiter Folgendes aufweist, wenn das Testauswahlsignal Bypass-Testung anzeigt:
Kombinieren der funktionalen Eingänge von der externen Logik zum Erzeugen einer verringerten Anzahl von funktionalen Eingängen gleich der Anzahl von funktionalen Ausgängen, während der Kern umgangen wird, und
Weiterleiten der reduzierten Anzahl von funktionalen Eingangsgrößen an die funktionalen Ausgänge, oder
ii) wenn es mehr funktionale Ausgänge als funktionale Eingänge gibt, das Verfahren weiter Folgendes aufweist, wenn das Testauswahlsignal Kernlogikfeedbacktestung anzeigt:
Kombinieren der Kernausgänge zum Erzeugen einer verringerten Anzahl von Kernausgängen gleich der Anzahl von funktionalen Eingängen, und
Zurückführen der verringerten Anzahl von Kernausgangsgrößen an die Kerneingänge.

15. Verfahren nach Anspruch 14, das weiter einen der folgenden Schritte aufweist:
i) Abhalten der verringerten Anzahl von funktionalen Eingangsgrößen an die funktionalen Ausgänge weitergeleitet zu werden, wenn ein At-Speed-Signal anzeigt, dass die externe Logik nicht zum Empfangen der reduzierten Anzahl von funktionalen Eingangsgrößen synchronisiert ist; oder
ii) Blockieren der Rückführung der reduzierten Anzahl von Kernausgangsgrößen an die Kerneingänge, wenn ein At-Speed-Signal anzeigt, dass die Kernlogikeingänge nicht zum Empfangen der Rückführung bzw. des Feedbacks der reduzierten Anzahl von Kernausgangsgrößen synchronisiert sind; oder
iii) wobei das Kombinieren unter Verwendung von Exclusive-OR-Logik stattfindet.

## Revendications

1. Architecture d'isolation et de contournement de balayage comprenant :
une logique centrale ayant une entrée de logique centrale et une sortie de logique centrale ;
un multiplexeur d'isolation d'entrée (212) présentant une première entrée, une seconde entrée, une entrée de sélection et une sortie, le multiplexeur d'isolation d'entrée (212) fournissant sélectivement une des première et seconde entrées du multiplexeur d'isolation d'entrée à la sortie du multiplexeur d'isolation d'entrée sur la base de l'entrée de sélection du multiplexeur d'isolation d'entrée (212), la première entrée du multiplexeur d'isolation d'entrée (212) étant couplée à une entrée fonctionnelle, la seconde entrée du multiplexeur d'isolation d'entrée (212) étant couplée à une sortie fonctionnelle, la sortie du multiplexeur d'isolation d'entrée (212) étant couplée à l'entrée de logique centrale, et l'entrée de sélection du multiplexeur d'isolation d'entrée (212) étant couplée à un premier signal de sélection de test ;
un multiplexeur d'isolation de sortie (214) ayant une première entrée, une seconde entrée, une entrée de sélection et une sortie, le multiplexeur d'isolation de sortie (214) fournissant sélectivement une des première et seconde entrées du multiplexeur d'isolation de sortie vers la sortie du multiplexeur d'isolation de sortie (214) sur la base de l'entrée de sélection du multiplexeur d'isolation de sortie (214), la première entrée du multiplexeur d'isolation de sortie (214) étant couplée à la sortie de logique centrale, la seconde entrée du multiplexeur d'isolation de sortie étant couplée à la sortie du multiplexeur d'isolation d'entrée (212), la sortie du multiplexeur d'isolation de sortie (214) fournissant la sortie fonctionnelle, et l'entrée de sélection du multiplexeur d'isolation de sortie (214) étant couplée à un second signal de sélection de test ;
dans laquelle lorsque les premier et second signaux de sélection de test indiquent un test de retour central, le multiplexeur d'isolation de sortie (214) passe la sortie de logique centrale de la première entrée du multiplexeur d'isolation de sortie (214) vers la sortie du multiplexeur d'isolation de sortie (214) à titre de sortie fonctionnelle, et le multiplexeur d'isolation d'entrée (212) passe la sortie de logique centrale de la seconde entrée du multiplexeur d'isolation d'entrée (212) vers la sortie du multiplexeur d'isolation d'entrée (212) et l'entrée de logique centrale.

2. Architecture d'isolation et de contournement de balayage selon la revendication 1, dans laquelle lorsque les premier et second signaux de sélection de test indiquent un test de contournement, le multiplexeur d'isolation d'entrée (212) passe l'entrée fonctionnelle de la première entrée du multiplexeur d'isolation d'entrée (212) vers la sortie du multiplexeur d'isolation d'entrée (212), et le multiplexeur d'isolation de sortie passe l'entrée fonctionnelle de la seconde entrée du multiplexeur d'isolation de sortie (214) vers la sortie du multiplexeur d'isolation de sortie (214) à titre de sortie fonctionnelle.

3. Architecture d'isolation et de contournement de balayage selon la revendication 2, dans laquelle lorsque les premier et second signaux de sélection de test indiquent un fonctionnement normal, le multiplexeur d'isolation d'entrée (212) passe l'entrée fonctionnelle de la première entrée du multiplexeur d'isolation d'entrée (212) vers la sortie du multiplexeur d'isolation d'entrée (212) pour être traitée par la logique centrale, et le multiplexeur d'isolation de sortie (214) passe la sortie de la logique centrale de la première entrée du multiplexeur d'isolation de sortie (214) vers la sortie du multiplexeur d'isolation de sortie (214) à titre de sortie fonctionnelle.

4. Architecture d'isolation et de contournement de balayage (200, 300, 400) selon la revendication 2 ou 3, comprenant en outre un signal à vitesse et une logique ET d'entrée (218), la logique ET d'entrée (218) comprenant :
une première entrée couplée au signal à vitesse,
une seconde entrée couplée à la sortie fonctionnelle, et
une sortie couplée à la seconde entrée du multiplexeur d'isolation d'entrée (212) ;
dans laquelle lorsque le signal à vitesse présente une première valeur, la logique ET d'entrée (218) passe la sortie fonctionnelle vers la sortie de la logique ET d'entrée (218), et lorsque le signal à vitesse présente une seconde valeur, la logique ET d'entrée (218) empêche la sortie fonctionnelle de passer vers la sortie de la logique ET d'entrée.

5. Architecture d'isolation et de contournement de balayage (200, 300, 400) selon la revendication 4, comprenant en outre une logique ET de sortie (220) comprenant :
une première entrée couplée au signal à vitesse,
une seconde entrée couplée à la sortie du moyen de sélection d'entrée (212), et
une sortie couplée à la seconde entrée du multiplexeur d'isolation de sortie (214) ;
dans laquelle lorsque le signal à vitesse présente la première valeur, la logique ET de sortie passe la sortie du multiplexeur d'isolation d'entrée (212) vers la sortie de la logique ET de sortie (220), et lorsque le signal à vitesse présente la seconde valeur, la logique ET de sortie (220) empêche la sortie du multiplexeur d'isolation d'entrée (212) de passer vers la sortie de la logique ET de sortie (220).

6. Architecture d'isolation et de contournement de balayage (200, 300, 400) selon la revendication 2 ou 3, comprenant en outre un signal à vitesse et une logique ET de sortie (220), la logique ET de sortie (220) comprenant :
une première entrée couplée au signal à vitesse,
une seconde entrée couplée à la sortie du multiplexeur d'isolation d'entrée (212), et
une sortie couplée à la seconde entrée du multiplexeur d'isolation de sortie (214) ;
dans laquelle lorsque le signal à vitesse présente une première valeur, la logique ET de sortie passe la sortie du multiplexeur d'isolation d'entrée (212) vers la sortie de la logique ET de sortie (220), et lorsque le signal à vitesse présente une seconde valeur, la logique ET de sortie (220) empêche la sortie du multiplexeur d'isolation d'entrée (212) de passer vers la sortie de la logique ET de sortie (220).

7. Architecture d'isolation et de contournement de balayage selon une quelconque revendication précédente 1, dans laquelle l'entrée fonctionnelle comprend N entrées et la sortie fonctionnelle comprend M sorties, N étant supérieur à M ; et dans laquelle l'architecture d'isolation et de contournement de balayage comprend en outre :
une logique OU exclusive (310) pour réduire le nombre d'entrées fonctionnelles à égalité avec le nombre de sorties fonctionnelles, la logique OU exclusive (310) comprenant :
une entrée couplée à la sortie du multiplexeur d'isolation d'entrée (212), et
une sortie couplée à la seconde entrée du multiplexeur d'isolation de sortie (214), la sortie du multiplexeur d'isolation d'entrée (212) étant couplée à la seconde entrée du multiplexeur d'isolation de sortie (214) par le biais de la logique OU exclusive (310).

8. Architecture d'isolation et de contournement de balayage selon la revendication 7, comprenant en outre un signal à vitesse et une logique ET de sortie (318), la logique ET de sortie comprenant :
une première entrée couplée au signal à vitesse,
une seconde entrée couplée à la sortie de la logique OU exclusive (310), et
une sortie couplée à la seconde entrée du multiplexeur d'isolation de sortie (214), la sortie de la logique OU exclusive (310) étant couplée à la seconde entrée du multiplexeur d'isolation de sortie par le biais de la logique ET de sortie ;
dans laquelle lorsque le signal à vitesse présente une première valeur, la logique ET de sortie (318) passe la sortie de la logique OU exclusive (310) vers la sortie de la logique ET de sortie, et lorsque le signal à vitesse présente une seconde valeur, la logique ET de sortie empêche la sortie de la logique OU exclusive (310) de passer vers la sortie de la logique ET de sortie.

9. Architecture d'isolation et de contournement de balayage selon la revendication 1, dans laquelle la sortie fonctionnelle comprend N sorties et l'entrée fonctionnelle comprend M entrées, N étant supérieur à M ; et dans laquelle l'architecture d'isolation et de contournement de balayage comprend en outre :
une logique OU exclusive (410) pour réduire le nombre de sorties fonctionnelles à égalité avec le nombre d'entrées fonctionnelles, la logique OU exclusive (410) comprenant :
une entrée couplée à la sortie fonctionnelle, et
une sortie couplée à la seconde entrée du multiplexeur d'isolation d'entrée (212), la sortie fonctionnelle étant couplée à la seconde entrée du multiplexeur d'isolation d'entrée par le biais de la logique OU exclusive (410).

10. Architecture d'isolation et de contournement de balayage selon la revendication 9, comprenant en outre un signal à vitesse et une logique ET d'entrée (218), la logique ET d'entrée comprenant :
une première entrée couplée au signal à vitesse,
une seconde entrée couplée à la sortie de la logique OU exclusive (410), et
une sortie couplée à la seconde entrée du multiplexeur d'isolation d'entrée, la sortie de la logique OU exclusive (410) étant couplée à la seconde entrée du moyen de sélection d'entrée par le biais de la logique ET d'entrée (218) ;
dans laquelle lorsque le signal à vitesse présente une première valeur, la logique ET d'entrée (218) passe la sortie de la logique OU exclusive (410) vers la sortie de la logique ET d'entrée (218), et lorsque le signal à vitesse présente une seconde valeur, la logique ET d'entrée (218) empêche la sortie de la logique OU exclusive de passer vers la sortie de la logique ET d'entrée.

11. Architecture d'isolation et de contournement de balayage selon la revendication 1 incorporée dans un dispositif sélectionné parmi un groupe constitué d'un lecteur de musique, d'un lecteur vidéo, d'une unité de divertissement, d'un dispositif de navigation, d'un dispositif de communication, d'un assistant numérique personnel (PDA), d'une unité de données à emplacement fixe, et d'un ordinateur.

12. Procédé de test d'isolation et de contournement de balayage pour un noyau couplé à une logique externe en utilisant une architecture d'isolation et de contournement de balayage selon l'une quelconque des revendications 1 à 11, le noyau présentant des entrées centrales et des sorties centrales, la logique externe fournissant des entrées fonctionnelles aux entrées centrales et acceptant des sorties fonctionnelles des sorties centrales, le procédé comprenant :
le fait d'amener les entrées fonctionnelles depuis la logique externe à contourner le noyau et passer vers les sorties fonctionnelles lorsqu'un signal de sélection de test indique un test de contournement ;
le fait d'amener les entrées fonctionnelles à traiter par le noyau et les sorties centrales à passer vers la logique externe à titre de sorties fonctionnelles lorsque le signal de sélection de test indique un traitement normal ; et
**caractérisé par** l'étape consistant à
amener les sorties centrales à effectuer un retour vers les entrées centrales lorsque le signal de sélection de test indique un test de retour de logique centrale.

13. Procédé selon la revendication 12, comprenant en outre une ou plusieurs des étapes suivantes :
i) une fourniture des sorties centrales aux sorties fonctionnelles lorsque le signal de sélection de test indique un test de retour de logique centrale ;
ii) un blocage du retour des sorties centrales vers les entrées centrales lorsqu'un signal à vitesse indique que les entrées de logique centrale ne sont pas synchronisées pour recevoir la retour des sorties centrales ;
iii) un blocage d'un passage des entrées fonctionnelles à partir de la logique externe vers les sorties fonctionnelles lorsqu'un signal à vitesse indique que la logique externe n'est pas synchronisée pour recevoir les entrées fonctionnelles ; ou
iv) un blocage d'un passage des entrées fonctionnelles à partir de la logique externe vers les sorties fonctionnelles lorsqu'un signal à vitesse indique que la logique externe n'est pas synchronisée pour recevoir les entrées fonctionnelles.

14. Procédé selon la revendication 12, dans lequel
i) lorsqu'il existe plus d'entrées fonctionnelles que de sorties fonctionnelles, le procédé comprenant en outre, lorsque le signal de sélection de test indique un test de contournement :
une combinaison des entrées fonctionnelles à partir de la logique externe pour produire un nombre réduit d'entrées fonctionnelles égal au nombre de sorties fonctionnelles tout en contournant le noyau, et
un passage du nombre réduit d'entrées fonctionnelles vers les sorties fonctionnelles, ou
ii) lorsqu'il existe plus de sorties fonctionnelles que d'entrées fonctionnelles, le procédé comprenant en outre, lorsque le signal de sélection de test indique un test de retour de logique centrale :
une combinaison des sorties centrales pour produire un nombre réduit de sorties centrales égal au nombre d'entrées fonctionnelles, et
un acheminement en retour du nombre réduit de sorties centrales vers les entrées centrales.

15. Procédé selon la revendication 14, comprenant en outre une des étapes suivantes :
i) un blocage d'un passage du nombre réduit d'entrées fonctionnelles vers les sorties fonctionnelles lorsqu'un signal à vitesse indique que la logique externe n'est pas synchronisée pour recevoir le nombre réduit d'entrées fonctionnelles ; ou
ii) un blocage du retour du nombre réduit de sorties centrales vers les entrées centrales lorsqu'un signal à vitesse indique que les entrées de logique centrale ne sont pas synchronisées pour recevoir le retour du nombre réduit de sorties centrales ; ou
iii) dans lequel la combinaison est faite en utilisant une logique ou exclusive.
